# EUROPÄISCHE PATENTANMELDUNG

(11) **EP 0 877 544 A1**
(43) Veröffentlichungstag der Anmeldung: **11.11.1998**
(21) Anmeldenummer: 98810287.7
(22) Anmeldetag: 03.04.1998
(51) Int. Cl.: H05K 13/04

(54) **Einrichtung und Verfahren zur Montage von Halbleiterchips auf einem Substrat**

(30) Priorität: 30.04.1997 CH 1008/97
(71) Anmelder: ESEC Management SA, 6330 Cham (CH); ESEC SA, CH-6330 Cham/Steinhausen (CH)
(72) Erfinder: Vischer, Dieter, 6300 Zug (CH)

(57) **Zusammenfassung**

Eine Pick-and-Place-Einrichtung eines bei der Halbleitermontage verwendeten Die Bonders enthält einen Manipulator (1), der einen Chipgreifer (2) zwischen zwei mechanisch bestimmten Endlagen hin und her bewegt. Damit wird jeweils ein Chip (10, 10') an einem ersten Ort (A) von einem Chipträger (11) abgehoben, seitwärts verschoben und an einem zweiten Ort (B) auf ein Substrat (5) abgelegt. Am ersten Ort befindet sich ein Verschiebetisch (3), um jeweils einen Chip bereitzustellen, und eine Messkamera zur Lageermittlung des betreffenden Chips. Am zweiten Ort stellt eine Substrat-Vorschubeinheit 4 jeweils einen Substratplatz bereit, und eine Messkamera oder Sensormittel ermitteln die Lage dieses Substratplatzes. Dem Manipulator (1) ist eine Korrekturbewegungseinheit (9) zugeordnet, die aufgrund von Lage-Messwerten der Kameras oder Sensormittel steuerbar ist. Damit werden Lagefehler des bereitgestellten Chips (10, 10') sowie des bereitgestellten Substratplatzes jeweils spätestens vor dem Ablegen des Chips auf den Substratplatz kompensiert. Es wird dadurch eine lagegenaue Montage ohne entsprechend gesteigerte Genauigkeit der Bewegungsaggregate (1, 3, 4) sowie eine verminderte Zyklusdauer erzielt.

## Beschreibung

Bei der Halbleiterherstellung werden Halbleiterelemente auf einem Wafer in grosser Zahl nebeneinander mit einer integrierten Schaltung versehen. Jede Waferscheibe wird anschliessend auf einem Träger montiert, und die einzelnen Elemente werden voneinander mechanisch getrennt. Die so entstandenen Chips müssen bei der anschliessenden Halbleitermontage in einem ersten Arbeitsgang einzeln auf einem Substrat montiert werden. Hierfür werden sogenannte Pick-and-Place-Einrichtungen verwendet, die jeweils einen Chip an einem ersten Ort von einem Chipträger abheben, dann seitwärts verschieben und an einem zweiten Ort auf einen Substratplatz ablegen.

Eine bekannte solche Einrichtung enthält
- einen Manipulator, der einen zwischen zwei mechanisch bestimmten Endlagen hin und her beweglichen Chipgreifer aufweist,
- einen im Bereich der einen Endlage des Manipulators angeordneten Verschiebetisch zum Bereitstellen jeweils eines Chips am ersten Ort zwecks Übernahme durch den Chipgreifer, sowie eine auf den ersten Ort gerichteten ersten Messkamera zur Lageermittlung des bereitgestellten Chips, und

- eine im Bereich der anderen Endlage des Manipulators angeordnete Substrat-Vorschubeinheit zum Bereitstellen jeweils eines Substratplatzes am zweiten Ort zwecks Aufnahme des Chips vom Chipgreifer, sowie eine auf den zweiten Ort gerichtete zweite Messkamera oder Sensormittel zur Lageermittlung des bereitgestellten Substratplatzes.

Eine solche Pick-and-Place-Einrichtung ist Bestandteil eines als "Die Bonder" bezeichneten Montageautomaten. An derartige Einrichtungen werden extrem hohe Anforderungen bezüglich kurzer Taktzeit, mechanischer Steifigkeit und genauer Position der Chips auf dem jeweiligen Substratplatz gestellt. Eine hohe Lagegenauigkeit auf dem Substrat im Bereich von wenigen Mikrometern ist erforderlich für die Weiterverarbeitung der Chips auf dem sogenannten Wire Bonder, wo die auf dem Chip befindliche integrierte Schaltung an ihren Anschlussstellen (bond pads) mit Drahtverbindungen versehen wird.

Beim Pick-and-Place-Vorgang wird die Endlage des Chips relativ zum Substrat grundsätzlich beeinflusst von der Lage des am ersten Ort bereitgestellten Chips, den beiden Endlagen des Manipulators bzw. des von ihm bewegten Chipgreifers, und von der Lage des am zweiten Ort bereitgestellten Substratplatzes. Um den Genauigkeitsanforderungen gerecht zu werden, müssen deshalb bei bisher bekannten Montageeinrichtungen die massgeblichen Teilaggregate - Verschiebetisch am ersten Ort (sogenannter Wafertisch), Manipulator sowie Vorschubeinheit am zweiten Ort (sogenannter Indexer) - die entsprechend hohe Präzision aufweisen. Messkameras an beiden Orten dienen dazu, die Lage des bereitgestellten Chips bzw. Substratplatzes zu überwachen und aufgrund einer Bildverarbeitung den Wafertisch bzw. den Indexer zu steuern. Gemäss dem Stand der Technik wird, jedenfalls beim Wafertisch, zuerst eine Grobverschiebung und anschliessend, aufgrund des Kamera-Messignals, eine Feinpositionierung vorgenommen. - Zur Lageermittlung des Substratplatzes ist es möglich, am zweiten Ort anstelle einer (zweiten) Messkamera andere Sensormittel einzusetzen. Wird das Substrat durch sogenannte Leadframes gebildet, so können z.B. fotoelektrische Kantendetektoren verwendet werden, die mit Index-(Pass-)Bohrungen am Leadframe-Rand oder direkt mit Kanten der Chipinseln (Substratplätze) zusammenwirken; Sensoren dieser Art können ebenfalls Messignale liefern, welche die jeweilige Lage des Substratplatzes in der Ebene kennzeichnen.

Der bekannte Aufbau solcher Montageeinrichtungen bedingt einen sehr hohen Aufwand bei der Herstellung der genannten Teilaggregate und bei der Montage und Eichung der Einrichtung. Auch die jeweilige betriebliche Justierung auf ein neues Produkt ist zeitraubend. Ferner ist nachteilig, dass die während jedem Arbeitszyklus durchzuführende und relativ viel Zeit beanspruchende Bildverarbeitung mit anschliessender Feinbewegung die Taktzeit verlängert. Eine Leistungssteigerung (erhöhte Taktrate) bei Einhaltung ausreichender Genauigkeit und Erfüllung aller übrigen Erfordernisse scheint mit dem bisherigen Konzept der Einrichtung kaum mehr möglich oder würde zu untragbaren Kosten führen.

Mit der vorliegenden Erfindung soll eine Montageeinrichtung der eingangs angegebenen Art vorgeschlagen werden, welche die beim Stand der Technik bestehenden Schwierigkeiten und Nachteile überwindet. Es wird insbesondere eine Verkürzung der Zykluszeit ohne entsprechend gesteigerten Aufwand beim Wafertisch, dem Indexer und dem Manipulator angestrebt.

Diese Aufgabe wird erfindungsgemäss mit den kennzeichnenden Merkmalen des Patentanspruches 1 gelöst. Dementsprechend ist dem Manipulator eine Korrekturbewegungseinheit zugeordnet, die aufgrund von Lage-Messwerten der beiden Messkameras - bzw. der Messkamera am ersten Ort und den Sensormitteln am zweiten Ort - steuerbar ist. Sie ist vorgesehen, um am ersten Ort gemessene Lagefehler des bereitgestellten Chips und am zweiten Ort gemessene Lagefehler des bereitgestellten Substratplatzes jeweils spätestens vor dem Ablegen des Chips auf dem Substratplatz zu kompensieren.

Mit der Erfindung wird vor allem erreicht, dass bei den beiden Teiloperationen - Bereitstellen des Chips und Bereitstellen des Substratplatzes - gewisse Lageabweichungen toleriert werden können. Diese werden mittels Korrekturbewegungen kompensiert, vorzugsweise in einem Vorgang gegen Ende des Arbeitszyklus, unmittelbar vor dem Ablegen des Chips. Dadurch kann auch die Unterteilung in Grob- und Feinbewegung bei den genannten Teilaggregaten entfallen, was einen Zeitgewinn erlaubt. Die bei der Erfindung verwendete Korrekturbewegungseinheit benötigt nur einen geringen Wegbereich (Grössenordnung wenige Zehntel Millimeter) und kann die erforderlichen Bewegungen sehr rasch und genau ausführen.

Bei einer im Anspruch 2 angegebenen Variante der erfindungsgemässen Einrichtung sind zusätzlich zur Erfassung der Endlagen des Manipulators bzw. des Chipgreifers Lagesensoren vorgesehen. Deren Messwerte werden bei der Kompensation durch die Korrekturbewegungseinheit mit einbezogen. Damit können auch auftretende Ungenauigkeiten des Manipulators, vor allem Langzeit-Drifterscheinungen erfasst und kompensiert werden.

Die Erfindung betrifft schliesslich, wie im Anspruch 3 angegeben, ein Montageverfahren unter Verwendung einer Einrichtung nach Anspruch 2.

Nachstehend wird die Erfindung anhand von Ausführungsbeispielen und in Verbindung mit der Zeichnung näher erläutert.
- Fig. 1: zeigt ein Ausführungsbeispiel einer Einrichtung mit schematischer, stark vereinfachter Darstellung des Manipulators und zugehörigen Teilaggregaten;
- Fig. 2: ist die perspektivische und detailliertere Darstellung einer Variante der Einrichtung;
- Fig. 3: ist ein Funktionsschema zur Einrichtung nach Fig. 2; und
- Fig. 4: ist ein Zeitdiagramm über einen Arbeitszyklus.

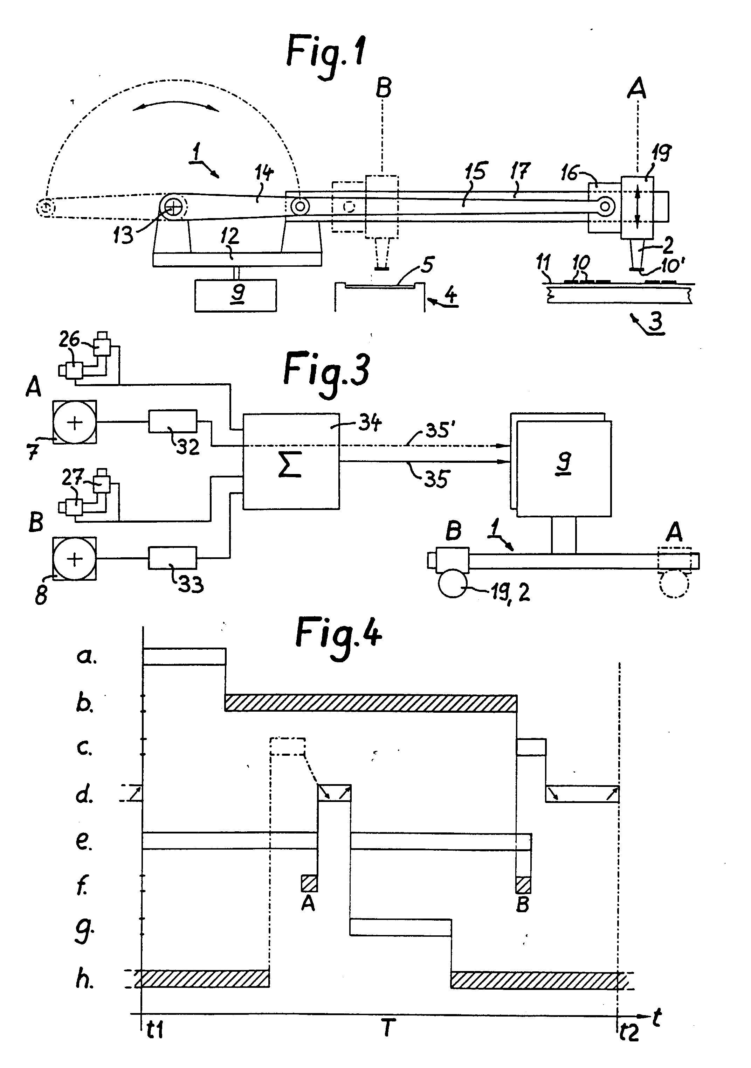

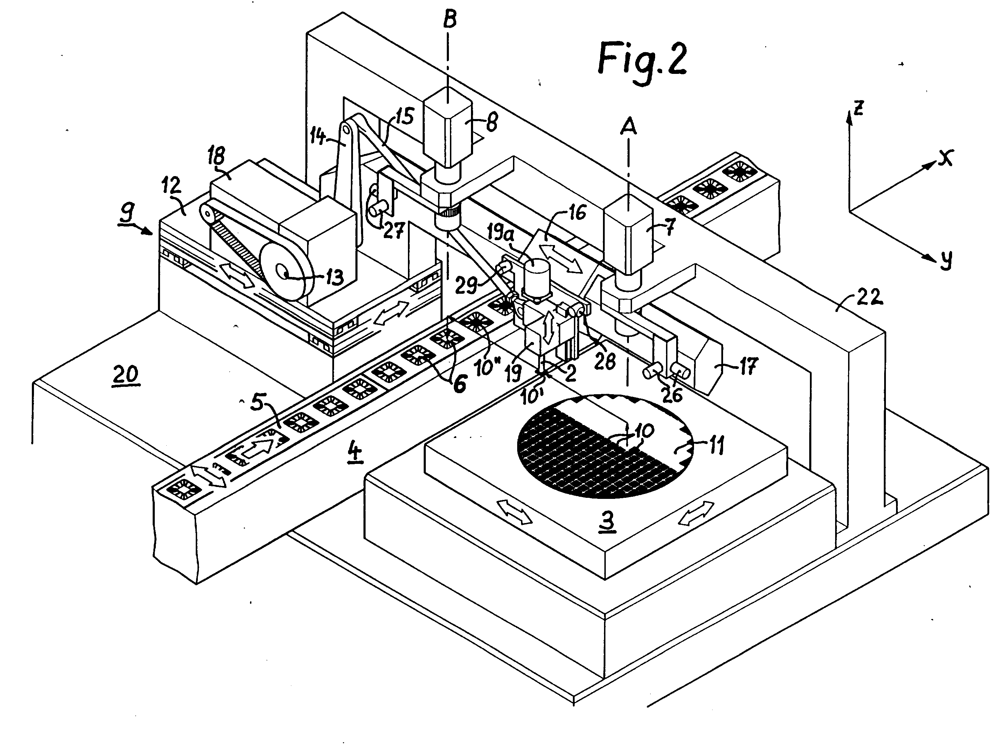

Die vereinfacht dargestellte Einrichtung nach Fig. 1 ist Teil eines Die Bonders, wie er bei der Halbleitermontage verwendet wird, um in an sich bekannter Weise Halbleiterchips 10 einzeln aus dem Wafer-Verband herauszuheben und auf einem Substrat 5 zu positionieren und dabei vorzugsweise mittels Klebstoff oder durch Weichlöten zu fixieren. Es wird hierfür ein Manipulator 1 verwendet, der mit einem Chipgreifer 2 versehen ist. Der Chipgreifer 2 ist Bestandteil eines vom Manipulator bewegten Bondkopfes 19 und ist auch heb- und senkbar. Bondkopf und Chipgreifer zusammen werden vom Manipulator zwischen zwei mechanisch bestimmten Endlagen hin und her bewegt. Im Bereich der einen Manipulator-Endlage ist ein Verschiebetisch 3 (sogenannter Wafertisch) angeordnet, auf dem sich die auf einem Chipträger 11 haftenden Chips 10 eines Wafers befinden. Der Verschiebetisch 3 stellt jeweils einen Chip 10' an einem bestimmten, ersten Ort A zur Übernahme durch den Chipgreifer 2 bereit. Im Bereich der anderen Manipulator-Endlage befindet sich eine Vorschubeinheit 4 (sogenannter Indexer) für ein mit Substratplätzen versehenes Substrat 5 (z.B. ein metallischer Leadframe). Die Vorschubeinheit bewegt das Substrat 5 schrittweise, um an einem zweiten Ort B jeweils einen Substratplatz bereitzustellen, der zur Aufnahme des vom Chipgreifer 2 herangeführten Chips 10' bestimmt ist.

Der erste Ort A und der zweite Ort B sind je durch die Achse einer Messkamera (7 bzw. 8, Fig. 2) definiert. Von diesen Messkameras werden mittels an sich bekannter Bildverarbeitungsverfahren während jedem Arbeitszyklus die Ist-Lage des bereitgestellten Chips (erster Ort A, Kamera 7) bzw. des bereitgestellten Substratplatzes (zweiter Ort B, Kamera 8) gemessen, d.h. zu entsprechenden Lage-Messwerten aufbereitet. Die Verwendung dieser Messwerte im Sinne der Erfindung wird weiter unten erläutert. - Bei den Ausführungsbeispielen sind zwei Messkameras dargestellt und beschrieben. Es ist jedoch festzuhalten, dass, wie weiter oben erwähnt, die Lage des bereitgestellten Substratplatzes am zweiten Ort B auch mit geeigneten Sensormitteln (Zentriersensor, Kantendetektor o. dgl.) gemessen werden kann.

Bei der dargestellten Einrichtung werden selbstverständlich die beiden Orte A, B einerseits und die beiden mechanisch bestimmten - zunächst als konstant angenommenen - Endlagen des Chipgreifers andererseits durch geeignete Justiereinrichtungen und -Verfahren möglichst genau in Übereinstimmung gebracht. Es ist indessen grundsätzlich zu unterscheiden zwischen den durch die Kameras definierten "Orten" und den vom Manipulator bestimmten "Endlagen", wie aus weiteren Ausführungen hiernach hervorgehen wird.

Der Manipulator 1 ist auf einer Grundplatte 12 aufgebaut und im vorliegenden Beispiel als sogenanntes Schubkurbel-Getriebe ausgeführt. Auf der Grundplatte 12 ist eine Antriebswelle 13 gelagert, die einen Schwingarm 14 trägt. Am Ende des Schwingarmes 14 ist die Schubstange 15 angelenkt. Deren entferntes Ende ist mit einem Schlitten 16 gelenkig verbunden, welcher seinerseits den Bondkopf 19 mit dem Chipgreifer 2 trägt. Der Schlitten 16 gleitet auf einer Linearführung, die wie das Lager der Welle 13 auf der Grundplatte 12 befestigt ist. Wie in Fig. 1 angedeutet, führen die Welle 13 und der Schwingarm 14 Drehbewegungen von 180° mit wechselnder Richtung aus, wobei der Schlitten 16 hin und her gleitet. Die beiden Strecklagen zwischen Schwingarm 14 und Schubstange 15 ergeben die beiden mechanischen Endlagen des Schlittens 16 bzw. des Chipgreifers 2 (die eine Endlage mit ausgezogenen Linien, die andere strichpunktiert gezeichnet). Im vorliegenden Zusammenhang wird ein Manipulator mit zwei stabilen, mechanisch bestimmten Endlagen vorausgesetzt; es ist hier jedoch festzuhalten, dass solche Endlagen auch auf andere Weise erreicht werden können als mit dem lediglich als Beispiel dargestellten Schubkurbel-Getriebe.

In Fig. 1 ist schliesslich rein schematisch eine dem Manipulator 1 zugeordnete bzw. mit diesem verbundene Korrekturbewegungseinheit 9 angedeutet. Auf deren Bedeutung und Wirkungsweise wird weiter unten eingegangen.

In Fig. 2 ist eine beispielsweise Einrichtung, die derjenigen nach Fig. 1 ähnlich ist, perspektivisch dargestellt, wobei Teile, die einander entsprechen, in beiden Figuren mit gleichen Bezugszahlen bezeichnet und nicht weiter zu erwähnen sind. Das Substrat (Leadframe) 5 weist Substratplätze 6 auf, die vom Indexer 4 schrittweise zum Ort B unter der Messkamera 8 vorgeschoben werden. Auf Substratplätzen fixierte und mit dem Substrat weitertransportierte Chips sind mit 10" bezeichnet. In Fig. 2 ist zusätzlich ein Antriebsblock 18 für die Welle 13 des Manipulators 1 dargestellt, ferner ein am Schlitten 16 montierter Motor 19a für die Vertikalbewegungen des Bondkopfes 19. Die Einrichtung ist gemäss Fig. 2 auf einem Sockel 20 aufgebaut.

Dieser trägt z.B. eine Traverse 22, an welcher die Messkameras 7 und 8 befestigt sind. Zur Ausrichtung der Kameras und des Bondkopfes 9 vorhandene Justiervorrichtungen sowie weitere, im vorliegenden Zusammenhang unwesentliche Einzelheiten sind nicht dargestellt.

Gemäss einer Variante kann die Einrichtung nach Fig. 2 im Bereich der beiden Endlagen des Manipulators 1 mit Lagesensoren 26 bzw. 27 und mit diesen zusammenwirkenden, am Schlitten 16 montierten Referenzflächen 28 bzw. 29 versehen sein. Diese zusätzlichen Messorgane ermöglichen, die jeweilige Position des Schlittens und damit des Chipgreifers 2 in den beiden Endlagen zu messen, indem die Sensoren 26, 27 Lage-Messwerte (in x- und y-Richtung) in Bezug auf die Sollage erzeugen. Davon kann, wie weiter unten ausgeführt, im Rahmen eines besonderen, erfindungsgemässen Chip-Montageverfahrens Gebrauch gemacht werden.

Die in Fig. 1 nur schematisch angedeutete, dem Manipulator 1 zugeordnete Korrekturbewegungseinheit 9 kann beispielsweise gemäss Fig. 2 als sogenannter Mikrotisch (Mikro-Manipulator) oder auch auf andere Weise realisiert sein. Diese Einheit ist vorgesehen, um in x- und y-Richtung (Fig. 2) sehr präzise und rasche Bewegungen innerhalb eines relativ kleinen Arbeitsbereiches auszuführen. Die Einheit 9 ist aufgrund von Lagemesswerten der beiden Messkameras 7 und 8 steuerbar, und ihre Korrekturbewegungen übertragen sich auf den Manipulator und damit auf den Chipgreifer 2.

Wie weiter oben ausgeführt, werden solche Lagemesswerte im Verlauf jedes Arbeitszyklus durch automatische Verarbeitung der Bilder beider Messkameras 7 und 8 (oder der Signale von Sensormitteln) erhalten und entsprechen Lagefehlern (in x- und y-Richtung) des am Ort A bereitgestellten Chips 1 bzw. des am Ort B bereitgestellten Substratplatzes 6. Derartige Lagefehler können verschiedene Ursachen haben, insbesondere sind sie durch begrenzte Bewegungsgenauigkeit des Wafertisches 3 und des Indexers 4 bedingt, die beide über einen relativ grossen Arbeitsbereich verfügen müssen. Indem nun die Bewegungseinheit 9 innerhalb des Arbeitszyklus entsprechend den genannten Messwerten gesteuert wird, werden die jeweiligen Lagefehler des bereitgestellten Chips und des bereitgestellten Substratplatzes kompensiert, und der Chip 10' wird vom Chipgreifer 2 lagegenau auf den Substratplatz übertragen.

Eine Korrekturbewegung der Einheit 9 muss natürlich spätestens jeweils vor dem Ablegen des Chips 10' auf dem Substratplatz erfolgen. Der Lagefehler des bereitgestellten Chips kann bereits etwa in der "Halbzeit" des Zyklus, d.h. vor dem Abheben des Chips vom Chipträger 11, durch Steuerung der Einheit 9 kompensiert werden. Dies ist dann zweckmässig, wenn es sich beim Chipgreifer 2 um ein sogenanntes Die Collect-Werkzeug handelt, welches die Chips an ihren oberen Randkanten erfasst, was eine genaue Ausrichtung zwischen Greifer und Chip voraussetzt. Andernfalls - bei Ergreifung der Chips an ihrer Oberseite, z.B. mit einem Sauggreifer - ist es besonders vorteilhaft, den am ersten Ort A ermittelten Lage-Messwert jeweils zu speichern, dann zum nachher am Ort B ermittelten Wert vektoriell zu addieren und die Einheit 9 mit der Summe, also nur einmal gegen Ende des Zyklus, zu steuern; bei der vektoriellen Addition können sich die Werte teilweise (nach x- und y-Komponenten) kompensieren, so dass die Korrekturbewegung insgesamt kleiner ausfällt.

Im folgenden wird noch anhand der Fig. 3 und 4 die Funktion der Einrichtung und das Montageverfahren unter Einbezug von Sensoren 26, 27 (Fig. 2) erläutert. Im Funktionsschema nach Fig. 3 sind die Sensoren 26 und die Messkamera 7 am ersten Ort A sowie die Sensoren 27 und die Messkamera 8 am zweiten Ort B jeweils mit den von ihnen ausgehenden Signalleitungen dargestellt. Mit 32 und 33 sind den Kameras 7 bzw. 8 zugeordnete Bildverarbeitungsschaltungen bezeichnet, an deren Ausgängen die jeweiligen Lage-Messwerte des bereitgestellten Chips bzw. des bereitgestellten Substratplatzes erscheinen. Die vier jeweils im Verlaufe eines Arbeitszyklus erfassten Messwerte - entsprechend seitlichen Lagefehlern des Chips, des Substratplatzes und des Chipgreifers an den Orten A und B - werden einer Speicher- und Addierschaltung 34 zugeleitet. In einer solchen, an sich bekannten Schaltung wird die vektorielle Summe der genannten Lage-Messwerte gebildet. Die gebildete Vektorsumme (x- und y-Komponenten) wird im geeigneten Moment abgerufen und, wie mit der Leitung 35 angedeutet, der Korrekturbewegungseinheit 9 zugeleitet. Aufgrund dieser Steuerung führt die Einheit 9 am Manipulator 1 die erforderliche Korrekturbewegung aus, um den Chipgreifer mit dem Chip 10' über dem Substratplatz genau zu positionieren

Gemäss vorstehendem Beispiel werden alle im Laufe eines Zyklus gemessenen Lagefehler vektoriell addiert und mit einem einzigen Korrekturvorgang am Manipulator unmittelbar vor dem Ablegen des Chips auf dem Substratplatz (Beginn des Bondvorganges) kompensiert.

Es kann jedoch gemäss einer Verfahrensvariante zweckmässig sein, z.B. den gemessenen Lagefehler des bereitgestellten Chips (Messwert der Kamera 7) für sich allein, ohne in die Addition in der Schaltung 34 einbezogen zu werden, zu kompensieren, und zwar vor dem Abheben des Chips vom Chipträger 11. Diese Variante ist in der Fig. 3 mit der strichpunktierten Linie 35' angedeutet. In diesem Fall führt also die Einheit 9 während eines Zyklus jeweils zwei Korrekturbewegungen aus.

Im Zeitdiagramm nach Fig. 4 stellen die untereinander gezeichneten horizontalen Balken folgende Teilfunktionen und -zeiten innerhalb eines Arbeitszyklus T dar:
a. Bewegung des Indexers 4
b. Auswertung des Bildes der Kamera 8 (Lage des Substratplatzes am Ort B)
c. Korrekturbewegung(en) der Einheit 9
d. Vertikalbewegungen des Bondkopfes 19 mit dem Chipgreifer 2 (z-Richtung, Fig. 2),
e. Seitwärtsbewegungen des Manipulators 1 ("holen" und "bringen", y-Richtung, Fig. 2)
f. Messvorgänge der Sensoren 26, 27 in A bzw. B
g. Bewegung des Wafertisches 3
h. Auswertung des Bildes der Kamera 7 (Lage des Chips am Ort A)

Sämtliche im folgenden beschriebenen Vorgänge sind selbstverständlich programmgesteuert. Als Beginn eines neuen Zyklus T ist der Zeitpunkt t1 angenommen, wo nach Ende des Bondvorganges im vorangehenden Zyklus (Balken d.) der Indexer 4 startet, um einen neuen Substratplatz 6 bereitzustellen. Nach erfolgtem Vorschub des Substrates 5 beginnt die Auswertung des von der Messkamera 8 aufgenommenen Bildes (Balken b.), um die Position des neu bereitgestellten Substratplatzes 6 festzustellen. Gleichzeitig mit dem Start des Indexers 4 ist der Manipulator 1 in Bewegung gesetzt worden (Balken e.). Er führt den Bondkopf 19 zum Ort A, um dort den (im Verlaufe des vorangehenden Zyklus) vom Wafertisch 3 bereitgestellten Chip 10 zu holen. Vor dem Erreichen der Endlage des Manipulators bzw. des Bondkopfes 19 mit dem Chipgreifer 2 über dem Wafertisch stehen die Messwerte betreffend die Position des bereitgestellten Chips aus der Bildverarbeitung der Kamera 7 (Balken h.) zur Verfügung. Es folgt nun das Abheben des Chips vom Chipträger 11 durch schnelles Absenken und Anheben des Bondkopfes 19 (Balken d.). Anschliessend führt der Manipulator mit dem vom Chipgreifer 2 gefassten Chip 10' die Rückbewegung zum Ort B aus. Gleichzeitig mit dem Manipulator wird auch der Wafertisch 3 gestartet, um einen nächsten Chip bereitzustellen (Balken g.), und anschliessend beginnt die Auswertung des von der Kamera 7 aufgenommenen Bildes (Balken h.). Bevor der Manipulator den Bondkopf an den Ort B gebracht hat, sind die Ergebnisse der Bildverarbeitung der Kamera 8 verfügbar, d.h. die genaue Position des neuen Substratplatzes 6 ist bekannt. Aufgrund der betreffenden Messwerte sowie gepeicherter und addierter weiterer, im Verlauf des Zyklus erfasster Fehler-Messwerte erfolgt nun die Steuerung der Korrekturbewegungseinheit 9, wodurch der Chip 10' genau über dem Substratplatz 6 positioniert wird. Unmittelbar danach legt der Bondkopf 19 den Chip auf dem Substratplatz ab, und es folgt der Bondvorgang. Dieser - und damit der Arbeitszyklus - wird mit dem erneuten Anheben des Bondkopfes abgeschlossen (Balken d., Zeitpunkt t2).

Sofern die Einrichtung mit Sensoren 26, 27 für die Endlagen des Bondkopfes versehen ist, treten diese jeweils zu den Zeitpunkten gemäss Balken f. in Aktion, und deren Messwerte werden in die Speicherung, Addition und Korrekturbewegung einbezogen, wie weiter oben anhand der Fig. 3 erläutert wurde. Wie ferner in Fig. 4, Balken c. strichpunktiert angedeutet und ebenfalls weiter oben ausgeführt, kann eine teilweise Fehlerkompensation bereits vor dem Abheben des Chips vom Chipträger 11 erfolgen, indem die Einheit 9 aufgrund der Lagefehler-Messwerte des bereitgestellten Chips (Kamera A, Balken h.) gesteuert wird. Dies entspricht also der mit der Linie 35' in Fig. 3 angegebenen Variante, bei der der Lagefehler des bereitgestellten Chips nicht in die Summierung einbezogen wird.

## Patentansprüche

1. Einrichtung zur Montage von Halbleiterchips (10) auf einem Substrat (5), wobei jeweils ein Chip an einem ersten Ort (A) von einem Chipträger (11) abgehoben, seitwärts verschoben und an einem zweiten Ort (B) auf einen Substratplatz (6) abgelegt wird,
- mit einem Manipulator (1), der einen zwischen zwei mechanisch bestimmten Endlagen hin und her beweglichen Chipgreifer (2) aufweist,
- einem im Bereich der einen Endlage des Manipulators (1) angeordneten Verschiebetisch (3) zum Bereitstellen jeweils eines Chips (10) am ersten Ort (A) zwecks Übernahme durch den Chipgreifer (2), sowie einer auf den ersten Ort gerichteten ersten Messkamera (7) zur Lageermittlung des bereitgestellten Chips,
- einer im Bereich der anderen Endlage des Manipulators (1) angeordneten Substrat-Vorschubeinheit (4) zum Bereitstellen jeweils eines Substratplatzes (6) am zweiten Ort zwecks Aufnahme des Chips (10') vom Chipgreifer, sowie einer auf den zweiten Ort gerichteten zweiten Messkamera (8) oder Sensormitteln zur Lageermittlung des bereitgestellten Substratplatzes,
dadurch **gekennzeichnet**,
dass dem Manipulator (1) eine Korrekturbewegungseinheit (9) zugeordnet ist, die aufgrund von Lage-Messwerten der beiden Messkameras (7, 8) bzw. der Sensormittel steuerbar ist, um am ersten Ort (A) gemessene Lagefehler des bereitgestellten Chips und am zweiten Ort (B) gemessene Lagefehler des bereitgestellten Substratplatzes jeweils spätestens vor dem Ablegen eines Chips auf den Substratplatz zu kompensieren.

2. Einrichtung nach Anspruch 1, dadurch gekennzeichnet, dass im Bereich beider Endlagen des Manipulators (1) zum Zusammenwirken mit dem Chipgreifer (2) bestimmte Lagesensoren (26, 27, 28, 29) angeordnet sind, um in der jeweiligen Endlage die Position des Chipgreifers in Bezug auf den ersten (A) bzw. den zweiten Ort (B) zu messen, und dass die Korrekturbewegungseinheit (9) aufgrund von Lage-Messwerten der genannten Sensoren zusätzlich steuerbar ist.

3. Verfahren zur Montage von Halbleiterchips (10) auf einem Substrat (5) unter Verwendung einer Einrichtung nach Anspruch 2,
dadurch **gekennzeichnet**,
dass seitliche Lagefehler
- des Chips (10) nach dem Bereitstellen am ersten Ort (A),
- des Chipgreifers (2) vor dem Abheben am ersten Ort (A),
- des Substratplatzes (6) nach dem Bereitstellen am zweiten Ort (B), und
- des Chipgreifers (2) vor dem Ablegen am zweiten Ort (B) während jedem Arbeitszyklus gemessen werden,
dass die gemessenen Lagefehler mindestens teilweise vektoriell addiert und gespeichert werden
und dass zwecks lagegenauer Ablage des Chips (10) die ermittelte Fehlersumme am Manipulator (1) unmittelbar vor dem Ablegen des Chips durch Steuerung der Korrekturbewegungseinheit (9) kompensiert wird.

4. Verfahren nach Anspruch 3, dadurch gekennzeichnet, dass ein gemessener Lagefehler des Chips (10) nach dem Bereitstellen am ersten Ort (A), ohne in die Addition einbezogen zu werden, am Manipulator (1) unmittelbar vor dem Abheben des Chips kompensiert wird.
